# EUROPEAN PATENT SPECIFICATION

(11) **EP 1 054 414 B1**
(45) Date of publication and mention of the grant of the patent: **12.03.2003**
(21) Application number: 99201645.1
(22) Date of filing: 20.05.1999
(51) Int. Cl.: H01B 1/12, C08G 61/12, H01M 4/60

(54) **Method for patterning a layer of conductive polymer**
Verfahren zum Strukturieren einer Schicht aus leitfähigem Polymer
Procédé pour structurer une couche de polymère conductrice

(43) Date of publication of application: 22.11.2000
(73) Proprietor: AGFA-GEVAERT, 2640 Mortsel (BE)
(72) Inventor: Cloots, Tom c/o Agfa Gevaert NV,, 2640 Mortsel (DE); Van Den Bogaert, Roger c/o Agfa Gevaert NV,, 2640 Mortsel (DE); Tahon, Jean-Pierre c/o Agfa Gevaert NV,, 2640 Mortsel (DE); Louwet, Frank c/o Agfa Gevaert NV,, 2640 Mortsel (DE)

(56) References cited:
- EP-A- 0 615 256
- WO-A-97/18944
- US-A- 4 959 430

## Description

### FIELD OF THE INVENTION

This invention relates to intrinsic conductive polymers. In particular to the patterning of layers of such polymers in order to form electrodes on said layers.

### DETAILED DESCRIPTION

It is known in the art of fabrication of flexible LC displays, electroluminescent devices and so on to replace the transparent ITO (Indium-Tinoxide) electrodes by transparent electrodes made with intrinsically conductive polymers as e.g. polyacetylene, polypyrrole, polyaniline, polythiophene, etc. The advantage of this replacement resides mainly in the fact that electrodes made with conductive polymers are much more flexible and less brittle than ITO electrodes so that, especially in the manufacture of touch screens, where high flexible electrodes are needed, the life-time of the device can be prolonged.

Different methods for forming tracks of electrodes made from intrinsic conductive polymers have been disclosed. In **WO-A-97 18944** a continuous layer of a conductive polymer is applied to the substrate, a mask is applied on top of said layer and the no masked parts are etched. After washing the mask away a pattern of electrodes is produced. In **US-A-5 561 030** basically the same procedure is used to form the pattern except for the fact that the pattern is formed in a continuous layer of prepolymer which is not yet conductive and that after washing the mask away the remaining prepolymer is rendered conductive by oxidation.

In **US-A-4 699 804** it is disclosed to apply a pattern of a polymerisation catalyst to a substrate and on that pattern a polymerizable compound. After reaction between the polymerisation catalyst and the polymerizable compound a pattern of conductive polymer is formed.

All methods above use some kind of lithography and etching processes as known from the classical PCB production and require a plurality of steps to be performed. There is thus a need to have a simple process, requiring a low number of steps, to prepare substrate with an electrode pattern.

### OBJECTS AND SUMMARY OF THE INVENTION

It is an object of the invention to provide a method for producing tracks of electrodes on a substrate wherein said electrodes are made of intrinsically conducting polymers requiring only a few number of process steps.

It is a further object of the invention to provide a method for producing tracks of electrodes on a substrate, said electrodes being made of intrinsically conducting polymers, wherein said tracks are formed by digital printing means.

Further objects and advantages of the invention will become clear from the description herein after.

The objects of the invention are realised by providing a method for producing a pattern of electrodes in a conductive polymer on a substrate comprising the steps of
- applying a layer containing between 10 and 5000 mg/m² of a conductive polymer on a substrate so as to prepare a conductive layer and
- printing an pattern on said layer using a printing solution containing of an oxidant selected from the group consisting of ClO⁻, BrO⁻, MnO₄⁻, Cr₂O₇⁻⁻, S₂O₈⁻⁻ and H₂O₂

### DETAILED DESCRIPTION OF THE INVENTION

It was found that an electrode pattern on a substrate wherein the electrodes are formed by a conductive polymer could be produced by applying a conductive layer on the substrate and then printing a pattern on said layer using a printing solution containing an oxidant. It was found that by printing a solution containing an oxidant the conductivity of the polymeric layer could be changed (diminished) by a factor between 10³ and 10¹¹ without changing the thickness of the layer. This is advantageous, especially when the electrode pattern is used in displays as, e.g., LDC's, since it makes it possible to use fewer spacing particles.

It is preferred to use an oxidant selected from the group consisting of ClO⁻, BrO⁻, MnO₄⁻, Cr₂O₇⁻⁻, S₂O₈⁻⁻ and H₂O₂. It is highly preferred to use ClO⁻ or MnO₄⁻ as oxidant. The use of MnO₄⁻ has the advantage that the influence on the conductivity of the conductive polymer is in a pH-range from 3 to 10 almost independent of the pH of the printing solution containing the MnO₄⁻ ions, so that no problems with ageing of the printing solution are encountered. The use of ClO⁻ as oxidant has the advantage that the printing solution can be used in low concentration or that, with printing solution containing a fairly high concentration, a small amount of printing solution can be used, thus avoiding problems with drying and spreading of the solution, which makes it possible to print lines as narrow as 5 µm. Therefore the use of ClO⁻ is most preferred.

The printing can proceed by offset printing, screen-printing or ink-jet printing.

Using a printing solution with a low concentration of ClO⁻ as oxidant makes it possible to prepare an ink that has a sufficient oxidising strength to change the conductivity of the conductive layer, but that is not so corrosive that it would be unusable in ink jet printing devices. The use of ink-jet printing devices has the advantage that no screen are necessary and that the electrode layout can be printed directly from the computer on the conductive layer.

For adjusting the viscosity of the solutions, a thickener is added selected from the group consisting of silica, silicates, clay, synthetic clays, e.g. the clays sold under trade name LAPONITE, and polymeric thickeners.

Optionally for easy printing the printing solution may comprise surfactants.

Although the printing works with layers containing any intrinsically conductive polymer known in the art, e.g., polyacetylene, polypyrrole, polyaniline, polythiophene, etc., it is preferred to use layers prepared by applying a mixture containing
(a) a polythiophene with formula 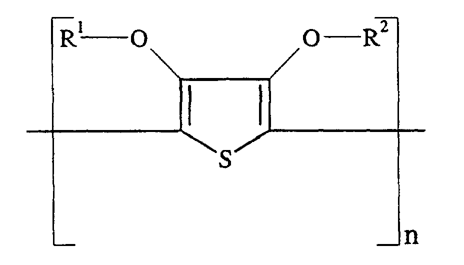 wherein each of R1 and R2 independently represents hydrogen or a C1-4 alkyl group or together represent an optionally substituted C1-4 alkylene group or a cycloalkylene group, preferably an ethylene group, an optionally alkyl-substituted methylene group, an optionally C1-12 alkyl- or phenyl-substituted 1,2-ethylene group, a 1,3-propylene group or a 1,2-cyclohexylene group,
(b) a polyanion compound and
(c) an organic compound containing 2 or more OH and/or COOH groups or amide or lactam groups. Such layers have been described in EP-A-686 662.

The printing can proceed on layers containing of a polyethylene-di-oxythiophene, polystyrenesulphonic acid wherein between 10 and 5000 mg/m² of the polythiophene is present, preferably layers wherein between 50 and 1000 mg/m² of the polythiophene is present are used and more preferably layers wherein between 75 and 500 mg/m² of the polythiophene is present are used. The layers comprising a conductive polymer and printed in the method of this invention, can have a any conductivity. The method of this invention can, e.g., be used to pattern layers with conductivity between 1 and 10⁵ S/cm. Preferably the conductive layers patterned by the method of this invention have conductivity between 5 and 10⁴ S/cm,more preferably between 10 and 1000 S/cm.

### EXAMPLES

### 1 Preparation of the polythiophene dispersion (PT) (hereinafter called dispersion PT)

a) Into 1000 ml of an aqueous solution of 14 g of polystyrene sulphonic acid (218 mmol of SO₃H groups) with number-average molecular weight (Mn) 40,000, were introduced 12.9 g of potassium peroxodisulfate (K₂S₂O₈), 0.1 g of Fe₂(SO₄)₃ and 5.68 g of 3,4-ethylenedioxy-thiophene. The thus obtained reaction mixture was stirred for 24 h at 20 °C and subjected to desalting.
b) 500 ml of the above prepared reaction mixture were diluted with 500 ml of water and stirred for 6 hours at room temperature in the presence of a granulated weak basic ion exchange resin LEWATIT H 600 (trade name of Bayer AG, Leverkusen, Germany) and strongly acidic ion exchanger LEWATIT S 100 (trade name of Bayer AG, Leverkusen, Germany). After said treatment the ion exchange resins were filtered off and the potassium ion and sulphate ion content were measured which were respectively 0.4 g K⁺ and 0.1 g (SO₄)²⁻ per litre.

### EXAMPLE 1

417 ml of dispersion PT and 50 g of methylpyrrolidone (compound A) were mixed with a binder (8.5 ml of a 30 % dispersion of co(vinylidenechloride/methylacrylate/itaconic acid 88/10/2) and a surfactant (0.5 ml of FLUORAD FC430, trade name of 3M) and the mixture was brought to 1000 ml with distilled water.

This mixture was coated on a 100 µm thick polyethyleneterephthalate film whereon a subbing layer (as usual on supports for photographic material) was present. The mixture was coated at a wet thickness of 40 mµ, and dried at a temperature of 35 °C.

The dried layer contained 200 mg/m² of polythiophene.

The resistivity in Ω/square was measured as described above and was 680 Ω/square.

### Printing example 1

On the layer a pattern was printed with screen printing using a printing solution containing ClO⁻ so that 25 mg/m² of NaClO was present. After printing the printing solution was washed away. The conductivity of the printed pattern was 10¹¹ times lower than the conductivity of the conductive layer.

### Printing example 2

On the layer a pattern was printed with screen printing using a printing solution containing MnO₄⁻ at pH = 3, so that 667 mg/m² of KMnO₄ was present. After printing the printing solution was washed away. The conductivity of the printed pattern was 10⁷ times lower than the conductivity of the conductive layer.

### Printing example 3

On the layer a pattern was printed with screen printing using a printing solution containing MnO₄⁻ at pH = 10, so that 667 mg/m² of KMnO₄ was present. After printing the printing solution was washed away. The conductivity of the printed pattern was 10⁷ times lower than the conductivity of the conductive layer.

### Printing example 4

On the layer a pattern was printed with screen printing using a printing solution containing (NH₄)₂S₂O₈ at pH = 10, so that 125 mg/m² of (NH₄)₂S₂O₈ was present. After printing the printing solution was washed away. The conductivity of the printed pattern was 10⁶ times lower than the conductivity of the conductive layer

### Printing example 5

On the layer a pattern was printed with screen printing using a printing solution containing (NH₄)₂S₂O₈ at pH = 2.6, so that 125 mg/m² of (NH₄)₂S₂O₈ was present. After printing the printing solution was washed away. The conductivity of the printed pattern was 10³times lower than the conductivity of the conductive layer

### Printing example 6

On the layer a pattern was printed with screen printing using a printing solution containing KIO₃ at pH = 2, so that 1250 mg/m² of KIO₃ was present. After printing the printing solution was washed away. The conductivity of the printed pattern was only 4 times lower than the conductivity of the conductive layer. Thus this oxidant is not useful in the method of this invention.

## Claims

1. A method for producing electrode pattern in a conductive polymer on a substrate comprising the steps of
- applying a layer containing between 10 and 5000 mg/m² of a conductive polymer, so as to prepare a conductive layer and
- printing an electrode pattern on said layer using a printing solution containing of an oxidant selected from the group consisting of ClO⁻, BrO⁻, MnO₄⁻, Cr₂O₇⁻⁻, S₂O₈⁻⁻ and H₂O₂.

2. A method according to claim 1, wherein said conductive layer has a conductivity between 1 and 10⁵ S/cm.

3. A method according to claim 1 or 2, wherein said conductive polymer has formula : 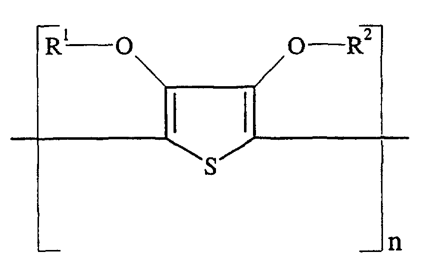 in which, each of R¹ and R² independently represents hydrogen or a C1-4 alkyl group or together represent an optionally substituted C1-4 alkylene group or a cycloalkylene group, preferably an ethylene group, an optionally alkyl-substituted methylene group, an optionally C1-12 alkyl- or phenyl-substituted 1,2-ethylene group, a 1,3-propylene group or a 1,2-cyclohexylene group.

4. A method according to claim 3, wherein said conductive polymer is applied from an aqueous solution containing a polyanion compound.

5. A method according to any of claims 1 to 4, wherein said printing proceeds by a printing method selected from the group consisting of offset printing, screen printing and ink-jet printing.

6. A method according to any of claims 1 to 5 wherein said printing proceeds so as to apply between 25 and 800 mg/m² of oxidant.

7. A method according to any of claims 1 to 6 wherein said printing solution comprises a thickener selected from the group consisting of silica, silicates, clay, synthetic clay and polymeric thickeners.

## Patentansprüche

1. Ein durch die nachstehenden Schritte gekennzeichnetes Verfahren zur Herstellung einer Elektrodenstruktur in einem leitfähigen Polymeren auf einem Substrat :
- Auftrag einer Schicht, die zwischen 10 und 5.000 mg/m² eines leitfähigen Polymeren enthält, um eine leitfähige Schicht zu bilden, und
- Drucken einer Elektrodenstruktur auf dieser Schicht, wobei eine Drucklösung, die ein Oxidans aus der Gruppe bestehend aus ClO⁻, BrO⁻, MnO₄⁻, Cr₂O₇⁻⁻, S₂O₈⁻⁻ und H₂O₂ enthält, benutzt wird.

2. Ein Verfahren nach Anspruch 1, **dadurch gekennzeichnet, daß** die Leitfähigkeit der leitfähigen Schicht zwischen 1 und 10⁵ S/cm liegt.

3. Ein Verfahren nach Anspruch 1 oder 2, **dadurch gekennzeichnet, daß** das leitfähige Polymere folgender Formel entspricht : 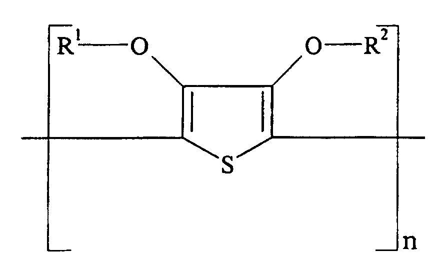 in der R¹ und R² unabhängig voneinander jeweils ein Wasserstoffatom oder eine C₁-C₄-Alkylgruppe bedeuten oder zusammen eine gegebenenfalls substituierte C₁-C₄-Alkylengruppe oder eine Cycloalkylengruppe, vorzugsweise eine Ethylengruppe, eine gegebenenfalls alkylsubstituierte Methylengruppe, eine gegebenenfalls C₁-C₁₂-alkyl- oder phenylsubstituierte 1,2-Ethylengruppe, eine 1,3-Propylengruppe oder eine 1,2-Cyclohexylengruppe bedeuten.

4. Ein Verfahren nach Anspruch 3, **dadurch gekennzeichnet, daß** das leitfähige Polymere aus einer wäßrigen, eine Polyanionverbindung enthaltenden Lösung aufgetragen wird.

5. Ein Verfahren nach einem der Ansprüche 1 bis 4, **dadurch gekennzeichnet, daß** als Drucktechnik Offsetdruck, Siebdruck oder Tintenstrahldruck angewandt wird.

6. Ein Verfahren nach einem der Ansprüche 1 bis 5, **dadurch gekennzeichnet, daß** beim Drucken ein Oxidansgehalt zwischen 25 und 800 mg/m² benutzt wird.

7. Ein Verfahren nach einem der Ansprüche 1 bis 6, **dadurch gekennzeichnet, daß** die Drucklösung ein Verdickungsmittel aus der Gruppe bestehend aus Kieselsäure, Silikaten, Ton, synthetischem Ton und polymeren Verdickungsmitteln enthält.

## Revendications

1. Procédé pour la production de structures d'électrodes dans un polymère conducteur sur un substrat, comprenant les étapes consistant à :
- appliquer une couche contenant un polymère conducteur, à concurrence d'une valeur entre 10 et 500 mg/m², de façon à préparer une couche conductrice, et
- imprimer une structure d'électrodes sur ladite couche en utilisant une solution d'impression contenant un oxydant choisi parmi le groupe constitué par ClO⁻, BrO⁻, MnO₄⁻, Cr₂O₇⁻⁻, S₂O₈⁻⁻ et H₂O₂.

2. Procédé selon la revendication 1, dans lequel ladite couche conductrice possède une conductivité entre 1 et 10⁵ S/cm.

3. Procédé selon la revendication 1 ou 2, dans lequel ledit polymère conducteur répond à la formule : 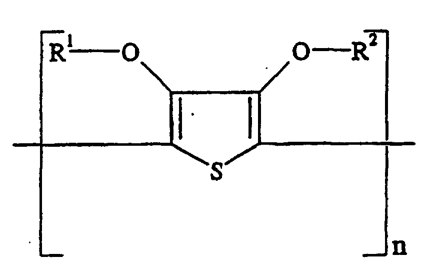 dans laquelle, chacun des radicaux R¹ et R² représente, indépendamment l'un de l'autre, un atome d'hydrogène ou un groupe alkyle en C₁-C₄, ou bien lesdits radicaux représentent ensemble un groupe alkylène en C₁-C₄, le cas échéant substitué, ou un groupe cycloalkylène, de préférence un groupe éthylène, un groupe méthylène, le cas échéant substitué par un groupe alkyle, un groupe 1,2-éthylène, le cas échéant substitué par un groupe alkyle en C₁-C₁₂ ou par un groupe phényle, un groupe 1,3-propylène ou un groupe 1,2-cyclohexylène.

4. Procédé selon la revendication 3, dans lequel ledit polymère conducteur est appliqué à partir d'une solution aqueuse contenant un composé polyanionique.

5. Procédé selon l'une quelconque des revendications 1 à 4, dans lequel ladite impression a lieu via un procédé d'impression choisi parmi le groupe constitué par l'impression offset, la sérigraphie et l'impression par jet d'encre.

6. Procédé selon l'une quelconque des revendications 1 à 5, dans lequel ladite impression a lieu de façon à appliquer l'oxydant à concurrence d'une valeur entre 25 et 800 mg/m².

7. Procédé selon l'une quelconque des revendications 1 à 6, dans lequel ladite solution d'impression comprend un épaississant choisi parmi le groupe constitué par de la silice, des silicates, de l'argile, de l'argile synthétique et des épaississants polymères.
